# EUROPEAN PATENT APPLICATION

(11) **EP 4 135 196 A1**
(43) Date of publication of application: **15.02.2023**
(21) Application number: 21934458.7
(22) Date of filing: 29.09.2021
(51) Int. Cl.: H03K 19/14

(54) **DIGITAL OUTPUT CIRCUIT, DIGITAL OUTPUT DEVICE, AND DIGITAL OUTPUT SYSTEM**

(30) Priority: 31.03.2021 CN 202110352904
(71) Applicant: Suzhou Inovance Technology Co., Ltd, Yuexi Town, Wuzhong District Suzhou, Jiangsu 215104 (CN)
(72) Inventor: LIU, Yang, Suzhou, Jiangsu 215104 (CN); LIU, Yan, Suzhou, Jiangsu 215104 (CN); LIU, Zhinan, Suzhou, Jiangsu 215104 (CN); XIONG, Fangyuan, Suzhou, Jiangsu 215104 (CN)
(74) Representative: Osterhoff, Utz
(86) International application number: PCT/CN2021/121788
(87) International publication number: WO 2022/205821

(57) **Abstract**

Disclosed are a digital output circuit, a digital output device and a digital output system. The digital output circuit includes: a digital output functional circuit; and a digital output leakage current detection circuit electrically connected to the digital output functional circuit. The digital output functional circuit is configured to turn on electrical connection between an input power supply and an upper computer to provide digital signal for the upper computer, and the digital output leakage current detection circuit is configured to perform leakage current detection on the digital signal, to control a switching state of the input power supply based on the leakage current detection result. The leakage current is detected on the digital signal of the digital output functional circuit through the digital output leakage current detection circuit, which improves the functional safety of the digital output.

## Description

### CROSS-REFERENCE TO RELATED APPLICATIONS

This application claims priority to Chinese Patent Application No. 202110352904.0, filed on March 31, 2021, and entitled "DIGITAL OUTPUT CIRCUIT, DIGITAL OUTPUT DEVICE AND DIGITAL OUTPUT SYSTEM", the entire contents of which are incorporated herein by reference.

### TECHNICAL FIELD

The present disclosure relates to the field of communication technologies, and in particular, to a digital output circuit, a digital output device and a digital output system.

### BACKGROUND

As the communication technology rapidly develops, the safety requirements for communication are demanding. Especially with the continuous upgrading of the industrial site environment, the safety requirements for industrial application sites are getting higher, that is, functional safety is becoming more important. In functional safety applications, safe digital output is an extremely important function. It can be understood that the safe digital output can ensure that the upper computer receives a reliable and safe signal. Therefore, it is necessary to construct a safe digital output circuit.

Nowadays, most of the safe digital output solutions are improved on the digital output functional circuit to improve into a safe digital output architecture. Since there are semiconductor devices in the digital output circuit, and the semiconductor devices often have leakage current when they are turned off. As a result, when the semiconductor device is turned off, an unexpected level is output by mistake, which in turn leads to the failure of the safe digital output function, thereby reducing the functional safety of the digital output. Therefore, how to improve the functional safety of digital output is an urgent problem to be solved.

### SUMMARY

The main objective of the present disclosure is to provide a digital output circuit, a digital output device and a digital output system, aiming at improving the functional safety of the digital output.

In order to achieve the above objective, the present disclosure provides a digital output circuit, including: a digital output functional circuit; and a digital output leakage current detection circuit electrically connected to the digital output functional circuit,
the digital output functional circuit is configured to turn on electrical connection between an input power supply and an upper computer to provide digital signal for the upper computer, and
the digital output leakage current detection circuit is configured to perform leakage current detection on the digital signal, to control a switching state of the input power supply based on the leakage current detection result.

In an embodiment, the digital output functional circuit includes a first photocoupler, a first voltage dividing resistor, a second voltage dividing resistor and a first triode; a positive electrode of an input end of the first photocoupler is electrically connected to a control integrated circuit (IC); a negative electrode of the input end of the first photocoupler is grounded; a positive electrode of an output end of the first photocoupler is electrically connected to a positive electrode of the input power supply through the first voltage dividing resistor; a negative electrode of the output end of the first photocoupler is electrically connected to a first end of the second voltage dividing resistor; a second end of the second voltage dividing resistor is electrically connected to a negative electrode of the input power supply or grounded; the negative electrode of the output end of the first photocoupler is electrically connected to a base electrode of the first triode; an emitting electrode of the first triode is electrically connected to the positive electrode of the input power supply; a collector electrode of the first triode is electrically connected to the upper computer;
the first photocoupler is configured to receive a first control signal sent by the control IC, to control a first on-off state of the first photocoupler based on the first control signal;
the first voltage dividing resistor is configured to form a first voltage dividing circuit with the second voltage dividing resistor, to use a voltage dividing level obtained by dividing the input power supply through the first voltage dividing circuit as a level at the base electrode of the first triode when the first on-off state is an on-state; and
the first triode is configured to control a second on-off state of the first triode based on the first on-off state, to control a level of the digital signal.

In an embodiment, the digital output functional circuit further includes a second photocoupler, a third voltage dividing resistor, a fourth voltage dividing resistor and a second triode; a positive electrode of an input end of the second photocoupler is electrically connected to the control IC; a negative electrode of the input end of the second photocoupler is grounded; a positive electrode of an output end of the second photocoupler is electrically connected to the collector electrode of the first triode through the third voltage dividing resistor; a negative electrode of the output end of the second photocoupler is electrically connected to a first end of the fourth voltage dividing resistor; a second end of the fourth voltage dividing resistor is electrically connected to the negative electrode of the input power supply or grounded; the negative electrode of the output end of the second photocoupler is electrically connected to a base electrode of the second triode; an emitting electrode of the second triode is electrically connected to the collector electrode of the first triode; a collector electrode of the second triode is electrically connected to the upper computer;
the second photocoupler is configured to receive a second control signal sent by the control IC, to control a third on-off state of the second photocoupler based on the second control signal;
the third voltage dividing resistor is configured to form a second voltage dividing circuit with the fourth voltage dividing resistor, to use a voltage dividing level obtained by dividing the input power supply through the second voltage dividing circuit as a level at the base electrode of the second triode when the third on-off state is an on-state; and
the second triode is configured to control a fourth on-off state of the second triode based on the third on-off state, to control a level of the digital signal.

In an embodiment, the digital output leakage current detection circuit includes a fifth voltage dividing resistor and a differential operational amplifier; a first end of the fifth voltage dividing resistor is electrically connected to an output end of the digital output functional circuit; a second end of the fifth voltage dividing resistor is electrically connected to a negative electrode of the input power supply or grounded; a non-inverting input end of the differential operational amplifier is electrically connected to the output end of the digital output functional circuit; an inverting input end of the differential operational amplifier is electrically connected to the negative electrode of the input power supply or grounded; an output end of the differential operational amplifier is electrically connected to the control IC; the fifth voltage dividing resistor is configured to divide the digital signal, to use the voltage dividing level as a level at the non-inverting input end of the differential operational amplifier; and
the differential operational amplifier is configured to amplify the level at the non-inverting input end, and output the amplified analog quantity to the control IC for the control IC to perform leakage current detection based on the analog quantity.

In an embodiment, the digital output leakage current detection circuit further includes a sixth voltage dividing resistor; a first end of the sixth voltage dividing resistor is electrically connected to the output end of the digital output functional circuit; a second end of the sixth voltage dividing resistor is electrically connected to the first end of the fifth voltage dividing resistor; and
the sixth voltage dividing resistor is configured to form a third voltage dividing circuit with the fifth voltage dividing resistor to use the voltage dividing level obtained by dividing the digital signal as the level at the non-inverting input end of the differential operational amplifier.

In an embodiment, the digital output circuit further includes a digital output power control circuit electrically connected to the input power supply; the digital output power control circuit is electrically connected to the digital output functional circuit; and
the digital output power control circuit is configured to control the switching state of the input power supply based on the leakage current detection result of the digital output leakage current detection circuit.

In an embodiment, the digital output power control circuit includes a third photocoupler, a seventh voltage dividing resistor, an eighth voltage dividing resistor, a third triode, a ninth voltage dividing resistor, a metal oxide semiconductor field effect transistor MOS and a tenth voltage dividing resistor; a positive electrode of an input end of the third photocoupler is electrically connected to the control IC; a negative electrode of the input end of the third photocoupler is grounded; a positive electrode of an output end of the third photocoupler is electrically connected to a positive electrode of the input power supply through the seventh voltage dividing resistor; a negative electrode of the output end of the third photocoupler is electrically connected to a first end of the eighth voltage dividing resistor; a second end of the eighth voltage dividing resistor is electrically connected to a negative electrode of the input power supply or grounded; the positive electrode of the output end of the third photocoupler is electrically connected to a base electrode of the third triode; an emitting electrode of the third triode is electrically connected to the positive electrode of the input power supply; a collector electrode of the third triode is electrically connected to a first end of the ninth voltage dividing resistor; a second end of the ninth voltage dividing resistor is electrically connected to the negative electrode of the input power supply or grounded; a source of the MOS is electrically connected to the positive electrode of the input power supply; a gate of the MOS is electrically connected to the positive electrode of the input power supply through the tenth voltage dividing resistor; the gate of the MOS is electrically connected to the collector electrode of the third triode; a drain of the MOS is electrically connected to an input power supply end of the digital output functional circuit;
the third photocoupler is configured to receive a power supply control signal sent by the control IC, to control a fifth on-off state of the third photocoupler based on the power supply control signal;
the seventh voltage dividing resistor is configured to form a fourth voltage dividing circuit with the eighth voltage dividing resistor, to use the voltage dividing level obtained by dividing the input power through the fourth voltage dividing circuit as a level at the base electrode of the third triode when the fifth on-off state is an on state;
the third triode is configured to control a sixth on-off state of the third triode based on the fifth on-off state, to determine a level at the gate of the MOS based on the sixth on-off state;
the ninth voltage dividing resistor is configured to form a fifth voltage dividing circuit with the first voltage dividing resistor, to use the voltage dividing level obtained by dividing the input power supply through the fifth voltage dividing circuit as the level at the gate of the MOS when the sixth on-off state is an off state; and
the MOS is configured to control a seventh on-off state of the MOS based on the sixth on-off state, to control the switching state of the input power supply based on the seventh on-off state.

In an embodiment, the digital output circuit further includes a control IC, a first control output pin of the control IC is electrically connected to the digital output functional circuit; a second control output pin of the control IC is electrically connected to the digital output functional circuit; an analog input pin of the control IC is electrically connected to the digital output leakage current detection circuit; a power control output pin of the control IC is electrically connected to the digital output power control circuit;
the control IC is configured to control the level of the digital signal based on a first control signal of the first control output pin and a second control signal of the second control output pin;
the control IC is further configured to receive an analog quantity sent by the digital output leakage current detection circuit, and determine a leakage current detection result based on the analog quantity; and
the control IC is further configured to control the switching state of the input power supply based on the leakage current detection result.

In addition, in order to achieve the above objective, the present disclosure provides a digital output device, including: the digital output circuit as described above.

Besides, in order to achieve the above objective, the present disclosure provides a digital output system, including: an input power supply device, an upper computer and the digital output circuit as described above.

The input power supply device is configured to supply power to the digital output circuit.

The upper computer is configured to receive digital signal output by the digital output circuit.

The present disclosure provides a digital output circuit, a digital output device and a digital output system. The digital output circuit includes a digital output functional circuit and a digital output leakage current detection circuit electrically connected to the digital output functional circuit. The digital output functional circuit is configured to turn on electrical connection between an input power supply and an upper computer to provide digital signal for the upper computer, and the digital output leakage current detection circuit is configured to perform leakage current detection on the digital signal, to control a switching state of the input power supply based on the leakage current detection result. The above-mentioned digital output leakage current detection circuit performs leakage current detection on the digital signal of the digital output functional circuit, to ensure that the digital signal input to the upper computer will not be affected by the leakage current, that is, and ensure the reliability and safety of the digital signal, thereby improving the functional safety of the digital output.

### BRIEF DESCRIPTION OF THE DRAWINGS

FIG. 1 is a schematic structural diagram of a digital output circuit according to a first embodiment of the present disclosure.
FIG. 2 is a schematic structural diagram of the digital output circuit according to a second embodiment of the present disclosure.
FIG. 3 is a schematic structural diagram of the digital output circuit according to a third embodiment of the present disclosure.
FIG. 4 is a schematic structural diagram of the digital output circuit according to a fourth embodiment of the present disclosure.
FIG. 5 is a schematic structural diagram of the digital output circuit according to a fifth embodiment of the present disclosure.
FIG. 6 is a schematic structural diagram of the digital output circuit according to a sixth embodiment of the present disclosure.
FIG. 7 is a schematic structural diagram of a power control circuit according to an embodiment of the present disclosure.
FIG. 8 is a schematic structural diagram of the digital output circuit according to a seventh embodiment of the present disclosure.

The realization of the objective, functional characteristics, and advantages of the present disclosure are further described with reference to the accompanying drawings.

### DETAILED DESCRIPTION OF THE EMBODIMENTS

It should be understood that the specific embodiments described herein are only intended to explain the present disclosure, but not to limit the present disclosure.

In the following embodiments and the accompanying drawings, DO_VCC+ is an input power supply of a digital output functional circuit, DO_OUT is digital signal output by the digital output functional circuit, VCC- is a negative electrode of an input power supply of the entire digital output circuit, VSS+ is a positive electrode of an input power supply of a differential operational amplifier, VSS- is a negative electrode of the input power supply of the differential operational amplifier, VCC+ is a positive electrode of the input power supply of the entire digital output circuit, and DO_VCC is power control signal received by a digital output power control circuit.

The present disclosure provides a digital output circuit.

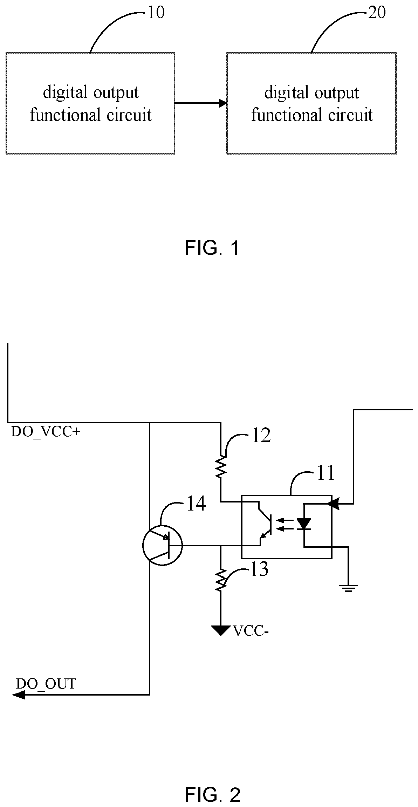

As shown in FIG. 1, FIG. 1 is a schematic structural diagram of a digital output circuit according to a first embodiment of the present disclosure.

In this embodiment, the digital output circuit includes a digital output functional circuit 10 and a digital output leakage current detection circuit 20.

The digital output leakage current detection circuit 10 is electrically connected to the digital output functional circuit 20. The output end of the digital output functional circuit 10 is electrically connected to the input end of the digital output leakage current detection circuit 20. That is to say, the digital signal output by the digital output functional circuit 10 can be used as the signal to be detected by the digital output leakage current detection circuit 20 to detect whether there is a leakage current signal in the digital signal. The output end of the digital output functional circuit 10 is configured to output digital signal to provide safe digital signal to the upper computer. The upper computer is the controlled device, which is configured to receive the digital signal and perform corresponding functions. The input end of the digital output leakage current detection circuit 20 is configured to receive the digital signal output by the digital output functional circuit 10 to detect whether the digital signal is safe, that is, whether there is leakage current.

The digital output functional circuit is configured to turn on electrical connection between an input power supply and an upper computer to provide digital signal for the upper computer.

The digital output leakage current detection circuit is configured to perform leakage current detection on the digital signal, to control a switching state of the input power supply based on the leakage current detection result.

It should be noted that the digital output functional circuit 10 includes a semiconductor device. When the semiconductor device is in the off state, leakage current may be generated, so that the digital output functional circuit 10 outputs the leakage current, that is, the output digital signal is at an unexpected level, resulting in an error of the connected upper computer.

In an embodiment, the digital output functional circuit 10 may be an improved safe digital output circuit, such as a dual-channel digital output architecture, to simultaneously control the output of the digital with dual control signals, thereby improving the functional safety of the digital output functional circuit 10. In other embodiments, the digital output functional circuit 10 may also be a single-channel digital output architecture, or other digital output functional circuits including semiconductor devices, which are not specifically limited herein. It should be noted that the input power supply of the digital output functional circuit 10 is an external power supply for supplying power, which can directly supply power to the digital output functional circuit 10, that is, the external power supply is directly connected to the digital output functional circuit 10. It is also possible to supply power to the digital output functional circuit 10 indirectly, that is, after the input power supply is processed by other circuits, the input power supply is then connected to the digital output functional circuit 10, for example, after the input power supply is preprocessed by the digital output power control circuit, the preprocessed input power supply is connected to the digital output functional circuit 10.

Besides, it should be noted that the digital output functional circuit 10 is configured to turn on the electrical connection between the input power supply and the upper computer. The digital output functional circuit 10 can control the level of the digital signal input to the upper computer, that is, control whether the digital level is high level or low level, for example, 5V (volt) is high level, 0V is low level. The high and low levels can be set according to actual needs, which is not limited herein.

It should also be noted that the digital output leakage current detection circuit 20 is mainly used for leakage current detection, and performing leakage current detection on the digital signal output by the digital output functional circuit 10 based on the digital output leakage current detection circuit 20, so as to obtain the leakage current state of the digital output in real time.

The switching state of the input power supply includes an on state and an off state. For example, if the leakage current detection result indicates that there is leakage current, the input power supply is cut off, that is, the input power supply is not connected to the digital output functional circuit 10, thereby ensuring no digital output.

In an embodiment, controlling the switching state of the input power supply based on the leakage current detection result can be implemented by the central processing unit. For example, the control integrated circuit (IC) receives the leakage current detection result, and then controls the switching state of the input power supply based on the leakage current detection result. Finally, the control IC can control the switching state of the input power supply through the digital output power control circuit. In other embodiments, the switching state of the input power supply can also be directly controlled by the digital output leakage current detection circuit 20.

The present disclosure provides a digital output circuit, a digital output device and a digital output system. The digital output circuit includes a digital output functional circuit and a digital output leakage current detection circuit electrically connected to the digital output functional circuit. The digital output functional circuit is configured to turn on electrical connection between an input power supply and an upper computer to provide digital signal for the upper computer, and the digital output leakage current detection circuit is configured to perform leakage current detection on the digital signal, to control a switching state of the input power supply based on the leakage current detection result. The above-mentioned digital output leakage current detection circuit performs leakage current detection on the digital signal of the digital output functional circuit, to ensure that the digital signal input to the upper computer will not be affected by the leakage current, that is, and ensure the reliability and safety of the digital signal, thereby improving the functional safety of the digital output.

Further, based on the first embodiment, the present disclosure provides a second embodiment of the digital output circuit.

As shown in FIG. 2, FIG. 2 is a schematic structural diagram of the digital output circuit according to a second embodiment of the present disclosure.

In this embodiment, the digital output functional circuit includes a first photocoupler 11, a first voltage dividing resistor 12, a second voltage dividing resistor 13 and a first triode 14.

A positive electrode of an input end of the first photocoupler 11 is electrically connected to a control integrated circuit (IC). A negative electrode of the input end of the first photocoupler 11 is grounded. A positive electrode of an output end of the first photocoupler 11 is electrically connected to a positive electrode of the input power supply through the first voltage dividing resistor 12. A negative electrode of the output end of the first photocoupler 11 is electrically connected to a first end of the second voltage dividing resistor 13. A second end of the second voltage dividing resistor 13 is electrically connected to a negative electrode of the input power supply or grounded. The negative electrode of the output end of the first photocoupler 11 is electrically connected to a base electrode of the first triode 14. An emitting electrode of the first triode 14 is electrically connected to the positive electrode of the input power supply. A collector electrode of the first triode 14 is electrically connected to the upper computer. The collector electrode of the first triode 14 may be directly electrically connected to the upper computer, or may be indirectly electrically connected to the upper computer through other circuits.

In an embodiment, the first triode 14 is a PNP type triode, and in other embodiments, the first triode 14 may also be other types of triodes, and the specific execution process is basically the same as that in this embodiment, and will not be repeated herein.

The first photocoupler is configured to receive a first control signal sent by the control IC, to control a first on-off state of the first photocoupler based on the first control signal.

It should be noted that the first photocoupler 11 is further configured to isolate the first control signal sent by the control IC from the input power supply to prevent static electricity or other electrical faults, thereby improving the stability of the digital output to further improve the functional safety of the digital output.

The first control signal includes a high-level signal and a low-level signal. For example, the high-level signal is 5V and the low-level signal is 0V. The high-level signal and the low-level signal can be set according to actual needs, which are not limited herein.

When the positive electrode of the input end of the first photocoupler 11 receives a high-level signal (the first control signal is the high-level signal), the first on-off state of the first photocoupler 11 is the on-state. When the positive electrode of the input end of the first photocoupler 11 receives a low-level signal (the first control signal is the low-level signal), the first on-off state of the first photocoupler 11 is the off state.

The first voltage dividing resistor is configured to form a first voltage dividing circuit with the second voltage dividing resistor, to use a voltage dividing level obtained by dividing the input power supply through the first voltage dividing circuit as a level at the base electrode of the first triode when the first on-off state is the on-state.

It should be noted that the first voltage dividing circuit formed by the first voltage dividing resistor 12 and the second voltage dividing resistor 13 can be configured for making sure that the level at the emitting electrode of the first triode 14 is greater than the level at he base electrode of the first triode 14 when the first on-off state is the on state, so that the first triode 14 is turned on.

For example, the level at the emitting electrode of the first triode 14 is 12V, and if the first voltage dividing resistor 12 is the same as the second voltage dividing resistor 13, the level at the base electrode of the first triode 14 is 6V.

When the first on-off state of the first photocoupler 11 is the on state, the level at the base electrode of the first triode 14 is the voltage dividing level of the input power supply through the first voltage dividing resistor 12 and the second voltage dividing resistor 13, so that the first triode 14 is turned on. When the first on-off state of the first photocoupler 11 is the off state, the first triode 14 is in the off state.

The first triode is configured to control a second on-off state of the first triode based on the first on-off state, to control a level of the digital signal.

It should be noted that when the first on-off state of the first photocoupler 11 is the on state, the level at the base electrode of the first triode 14 is the voltage dividing level of the input power supply through the first voltage dividing resistor 12 and the second voltage dividing resistor 13. Since the level at the emitting electrode of the first triode 14 is the level of the input power supply, the second on-off state of the first triode 14 is the on state, and at this time, the input power supply is turned on, that is, the level of the output digital signal is a high level. When the first on-off state of the first photocoupler 11 is the off state, the second on-off state of the first triode 14 is also the off state, and at this time, the input power supply cannot be turned on, that is, the level of the output digital signal is a low level.

It can be understood that only when the first control signal sent by the control IC is a high-level signal, the output digital signal is a high-level signal. Correspondingly, when the first control signal sent by the control IC is a low-level signal, the output digital signal is a low-level signal.

In this embodiment, the first control signal can be isolated from the input power supply through the first photocoupler to ensure the stability of the digital output functional circuit, thereby further improving the functional safety of the digital output.

Further, based on the second embodiment, the present disclosure provides a third embodiment of the digital output circuit.

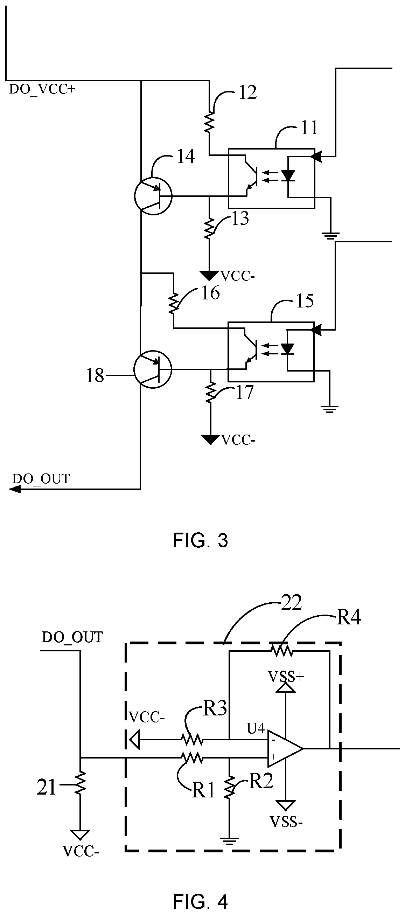

As shown in FIG. 3, FIG. 3 is a schematic structural diagram of the digital output circuit according to a third embodiment of the present disclosure.

In this embodiment, the digital output functional circuit further includes a second photocoupler 15, a third voltage dividing resistor 16, a fourth voltage dividing resistor 17 and a second triode 18.

A positive electrode of an input end of the second photocoupler is electrically connected to the control IC. A negative electrode of the input end of the second photocoupler is grounded. A positive electrode of an output end of the second photocoupler is electrically connected to the collector electrode of the first triode through the third voltage dividing resistor. A negative electrode of the output end of the second photocoupler is electrically connected to a first end of the fourth voltage dividing resistor. A second end of the fourth voltage dividing resistor is electrically connected to the negative electrode of the input power supply or grounded. The negative electrode of the output end of the second photocoupler is electrically connected to a base electrode of the second triode. An emitting electrode of the second triode is electrically connected to the collector electrode of the first triode. A collector electrode of the second triode is electrically connected to the upper computer.

In an embodiment, the second triode 18 is a PNP type triode, and in other embodiments, the second triode 18 may also be other types of triodes, and the specific execution process is basically the same as that in this embodiment, and will not be repeated herein.

The second photocoupler is configured to receive a second control signal sent by the control IC, to control a third on-off state of the first photocoupler based on the second control signal.

It should be noted that the second photocoupler 11 is further configured to isolate the second control signal sent by the control IC from the input power supply to prevent static electricity or other electrical faults, thereby improving the stability of the digital output to further improve the functional safety of the digital output.

The second control signal includes a high-level signal and a low-level signal. For example, the high-level signal is 5V and the low-level signal is 0V. The high-level signal and the low-level signal can be set according to actual needs, which are not limited herein.

When the positive electrode of the input end of the second photocoupler 15 receives a high-level signal (the second control signal is the high-level signal), the third on-off state of the second photocoupler 15 is the on-state. When the positive electrode of the input end of the second photocoupler 15 receives a low-level signal (the second control signal is the low-level signal), the second on-off state of the second photocoupler 15 is the off state.

The third voltage dividing resistor is configured to form a second voltage dividing circuit with the fourth voltage dividing resistor, to use a voltage dividing level obtained by dividing the input power supply through the second voltage dividing circuit as a level at the base electrode of the second triode when the third on-off state is the on-state.

It should be noted that the second voltage dividing circuit formed by the third voltage dividing resistor 16 and the fourth voltage dividing resistor 17 can be configured for making sure that the level at the emitting electrode of the second triode 18 is greater than the level at the base electrode of the second triode 18 when the third on-off state is the on state, so that the second triode 18 is turned on.

For example, the level at the emitting electrode of the second triode 18 is 6V, and if the third voltage dividing resistor 16 is the same as the fourth voltage dividing resistor 17, the level at the base electrode of the second triode 18 is 3V.

When the third on-off state of the second photocoupler 15 is the on state, and the second on-off state of the first triode 14 is the on-state, the level at the base electrode of the second triode 18 is the voltage divided by the level at the collector electrode of the first triode 14 through the third voltage dividing resistor 16 and the fourth voltage dividing resistor 17, so that the second triode 18 is turned on. When the third on-off state of the second photocoupler 15 is the off state, the second triode 18 is in the off state.

The second triode is configured to control a fourth on-off state of the second triode based on the third on-off state, to control a level of the digital signal.

It should be noted that when the third on-off state of the second photocoupler 15 is the on state, and the second on-off state of the first triode 14 is the on state, the level at the base electrode of the second triode 18 is the voltage divided by the level at the collector electrode of the first triode 14 through the third voltage dividing resistor 16 and the fourth voltage dividing resistor 17. Since the level at the emitting electrode of the second triode 18 is the level at the collector electrode of the first triode 14, the fourth on-off state of the second triode 18 is the on state, and at this time, the input power supply is turned on, that is, the level of the output digital signal is a high level. When the first on-off state of the second photocoupler 15 is the off state, the fourth on-off state of the second triode 18 is also the off state, and at this time, the input power supply cannot be turned on, that is, the level of the output digital signal is a low level.

It can be understood that only when the first control signal and the second control signal sent by the control IC are both high-level signals, the output digital signal is a high-level signal. Correspondingly, when the first control signal sent by the control IC is a low-level signal, or when the second control signal sent by the control IC is a low-level signal, the output digital signal is a low-level signal.

In this embodiment, the digital output functional circuit is a dual-channel digital output architecture, that is, the digital output functional circuit is controlled by dual-channel signals. Compared with the fact that the digital output functional circuit is controlled by the single-channel signal, this embodiment can further improve the functional safety of the digital output.

Further, based on the first embodiment, the present disclosure provides a fourth embodiment of the digital output circuit.

As shown in FIG. 4, FIG. 4 is a schematic structural diagram of the digital output circuit according to a fourth embodiment of the present disclosure.

In this embodiment, the digital output leakage current detection circuit includes a fifth voltage dividing resistor 21 and a differential operational amplifier 22.

A first end of the fifth voltage dividing resistor is electrically connected to an output end of the digital output functional circuit. A second end of the fifth voltage dividing resistor is electrically connected to a negative electrode of the input power supply or grounded. A non-inverting input end of the differential operational amplifier is electrically connected to the output end of the digital output functional circuit. An inverting input end of the differential operational amplifier is electrically connected to the negative electrode of the input power supply or grounded. An output end of the differential operational amplifier is electrically connected to the control IC.

The first end of the fifth voltage dividing resistor 21 is electrically connected to the output end of the digital output functional circuit, which receives the digital signal output by the digital output functional circuit, which can be directly connected or indirectly connected through other devices. For example, another voltage dividing resistor is connected in series with the first end of the fifth voltage dividing resistor 21. The output end of the differential operational amplifier 22 may be electrically connected to the analog input pin of the control IC, so as to input the analog signal output by the digital output leakage current detection circuit to the control IC, and complete the leakage current detection.

It should be noted that the differential operational amplifier 22 includes a first resistor R1 and a second resistor R2 on the non-inverting input end, a third resistor R3 and a feedback resistor R4 on the inverting input end. The details refer to FIG. 4.

The fifth voltage dividing resistor is configured to divide the digital signal, to use the voltage dividing level as a level at the non-inverting input end of the differential operational amplifier.

It should be noted that the fifth voltage dividing resistor 21 is configured to ensure that the level at the non-inverting input end of the differential operational amplifier is a required level, and prevent the level at the non-inverting input end from being an invalid level, such as 0V.

The differential operational amplifier is configured to amplify the level at the non-inverting input end, and output the amplified analog quantity to the control IC for the control IC to perform leakage current detection based on the analog quantity.

It should be noted that the differential operational amplifier 22 performs a differential operation on the divided digital signal to obtain an amplified differential result, and the differential result is an analog signal. Then, the analog signal is input to the control IC, so that the control IC converts the analog signal into the digital signal, thereby determining whether the level of the digital signal is greater than the preset threshold when the digital output functional circuit is turned off. If the level of the digital signal is greater than the preset threshold, it is determined that there is leakage current; if the level of the digital signal is less than or equal to the preset threshold, it is determined that there is no leakage current. The preset threshold value can be set according to the actual situation, which is not limited herein.

In an embodiment, the control IC can determine whether the digital output functional circuit is in the off state through the control of the digital output functional circuit. For example, when the first control signal of the control IC is at a low level or the second control signal of the control IC is at a low level, it can be determined that the digital output functional circuit is in an off state.

In another embodiment, the control IC can also determine whether there is leakage current through other methods. For example, if the level of the digital signal is greater than the first preset threshold and less than the second preset threshold, it is determined that there is a leakage current. If the level of the digital signal is less than or equal to the first preset threshold, it is determined that there is no leakage current. The second preset threshold is greater than the first preset threshold, and the second preset threshold is configured to determine whether the digital output functional circuit is in the off state. If the level of the digital signal is less than the second preset threshold, it is determined that the digital output functional circuit is in the off state. If the level of the digital signal is greater than or equal to the second preset threshold, it is determined that the digital output functional circuit is in the on state.

In this embodiment, the leakage current detection is performed on the output digital signal through the differential operational amplifier. Since the differential operational amplifier has a gain effect, the accuracy of the leakage current detection can be improved, thereby further improving the functional safety of the digital output.

Further, based on the first embodiment, the present disclosure provides a fifth embodiment of the digital output circuit.

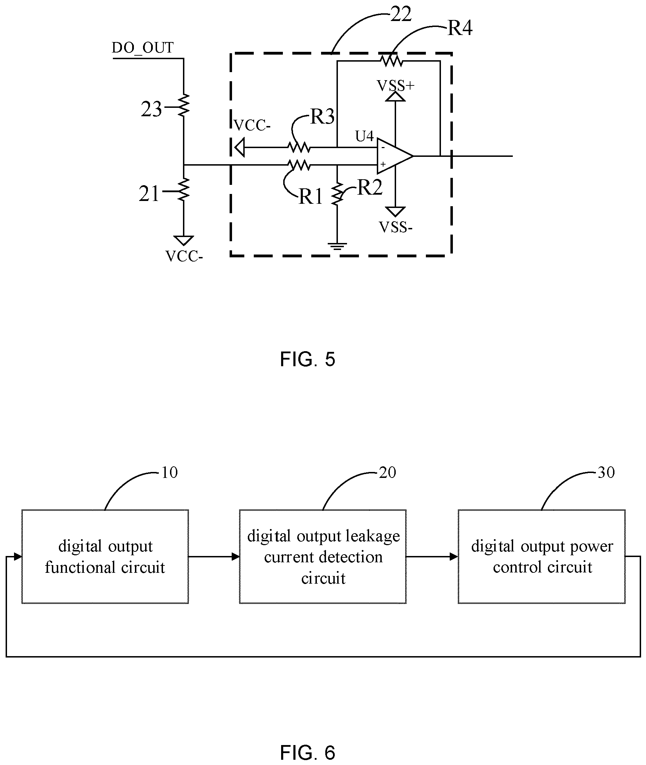

As shown in FIG. 5, FIG. 5 is a schematic structural diagram of the digital output circuit according to a fifth embodiment of the present disclosure.

In this embodiment, the digital output leakage current detection circuit further includes a sixth voltage dividing resistor 23. A first end of the sixth voltage dividing resistor 23 is electrically connected to the output end of the digital output functional circuit, and a second end of the sixth voltage dividing resistor 23 is electrically connected to the first end of the fifth voltage dividing resistor.

The sixth voltage dividing resistor is configured to form a third voltage dividing circuit with the fifth voltage dividing resistor to use the voltage dividing level obtained by dividing the digital signal as the level at the non-inverting input end of the differential operational amplifier.

It should be noted that when the fifth voltage dividing resistor 21 fails, due to the existence of the sixth voltage dividing resistor, it can be ensured that the level at the non-inverting input end of the differential operational amplifier 22 exists. Correspondingly, when the sixth voltage dividing resistor 23 fails, since the fifth voltage dividing resistor 21 still works normally, the normal operation of the digital output leakage current detection circuit can be ensured.

In this embodiment, when receiving the digital signal from the digital output functional circuit, adding the sixth voltage dividing resistor can ensure that the digital output leakage current detection circuit can still work normally when other resistors fail, thereby further improving the functional safety of the digital output.

Further, based on the first embodiment, the present disclosure provides a sixth embodiment of the digital output circuit.

As shown in FIG. 6, FIG. 6 is a schematic structural diagram of the digital output circuit according to a sixth embodiment of the present disclosure.

In this embodiment, the digital output circuit further includes a digital output power control circuit 30 electrically connected to the input power supply, and the digital output power control circuit is electrically connected to the digital output functional circuit.

It should be noted that the digital output power control circuit 30 is electrically connected to the input power supply. The digital output power control circuit is electrically connected to the digital output functional circuit 10. That is, the input power supplies power to the digital output functional circuit 10 indirectly through the digital output power control circuit 30.

The digital output power control circuit is configured to control the switching state of the input power supply based on the leakage current detection result of the digital output leakage current detection circuit.

In an embodiment, the switching state of the input power supply can be controlled based on the power supply control signal by receiving the power supply control signal of the control IC. The high level and low level of the power control signal can represent the leakage current detection result of the digital output leakage current detection circuit.

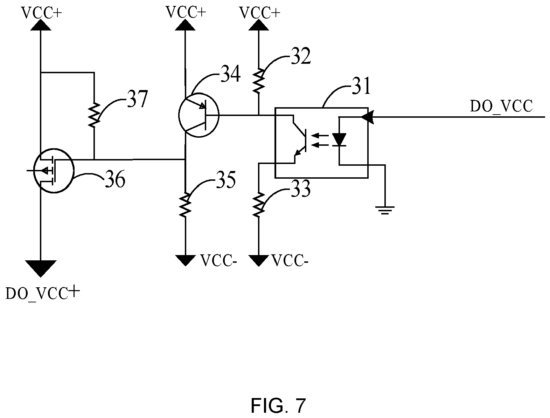

As shown in FIG. 7, FIG. 7 is a schematic structural diagram of a power control circuit according to an embodiment of the present disclosure. The digital output power control circuit 30 includes a third photocoupler 31, a seventh voltage dividing resistor 32, an eighth voltage dividing resistor 33, a third triode 34, a ninth voltage dividing resistor 35, a metal oxide semiconductor field effect transistor MOS 36 and a tenth voltage dividing resistor 37.

In this embodiment, a positive electrode of an input end of the third photocoupler 31 is electrically connected to the control IC. A negative electrode of the input end of the third photocoupler is grounded. A positive electrode of an output end of the third photocoupler 31 is electrically connected to a positive electrode of the input power supply through the seventh voltage dividing resistor 32. A negative electrode of the output end of the third photocoupler 31 is electrically connected to a first end of the eighth voltage dividing resistor 33. A second end of the eighth voltage dividing resistor 33 is electrically connected to a negative electrode of the input power supply or grounded. The positive electrode of the output end of the third photocoupler 31 is electrically connected to a base electrode of the third triode 34. An emitting electrode of the third triode 34 is electrically connected to the positive electrode of the input power supply. A collector electrode of the third triode 34 is electrically connected to a first end of the ninth voltage dividing resistor 35. A second end of the ninth voltage dividing resistor 35 is electrically connected to the negative electrode of the input power supply or grounded. A source of the MOS 36 is electrically connected to the positive electrode of the input power supply. A gate of the MOS 36 is electrically connected to the positive electrode of the input power supply through the tenth voltage dividing resistor 37. The gate of the MOS 36 is electrically connected to the collector electrode of the third triode 34. A drain of the MOS 36 is electrically connected to an input power supply end of the digital output functional circuit.

In an embodiment, the third triode 34 is a PNP type triode, and in other embodiments, the third triode 34 may also be other types of triodes, and the specific execution process is basically the same as that in this embodiment, and will not be repeated herein.

The third photocoupler 31 is configured to receive a power supply control signal sent by the control IC, to control a fifth on-off state of the third photocoupler 31 based on the power supply control signal.

It should be noted that the third photocoupler 31 is further configured to isolate the power control signal sent by the control IC from the input power to prevent static electricity or other electrical faults. Thus, the stability of the digital output power control circuit 30 is improved, so as to further improve the functional safety of the digital output.

The power control signal includes a high-level signal and a low-level signal. For example, the high-level signal is 5V, and the low-level signal is 0V. The high-level signal and the low-level signal can be set according to actual needs, which are not limited herein.

When the positive electrode of the input end of the third photocoupler 31 receives a high-level signal (the power control signal is a high-level signal), the fifth on-off state of the third photocoupler 31 is the on-state. When the positive electrode of the input end of the third photocoupler 31 receives a low-level signal (the power control signal is a low-level signal), the fifth on-off state of the third photocoupler 31 is the off state.

The seventh voltage dividing resistor 32 is configured to form a fourth voltage dividing circuit with the eighth voltage dividing resistor 33, to use the voltage dividing level obtained by dividing the input power through the fourth voltage dividing circuit as a level at the base electrode of the third triode 34 when the fifth on-off state is an on state.

It should be noted that the fourth voltage dividing circuit formed by the seventh voltage dividing resistor 32 and the eighth voltage dividing resistor 33 can be used for, when the fifth on-off state is the on state, making sure that the level at the emitting electrode of the third triode 34 is greater than the level at the base electrode of the third triode 34 so that the third triode 34 is turned on.

For example, the level at the emitting electrode of the third triode 34 is 24V, and if the seventh voltage dividing resistor 31 is the same as the eighth voltage dividing resistor 33, the level at the base electrode of the third triode 34 is 12V.

When the fifth on-off state of the third photocoupler 31 is the on state, the level at the base electrode of the third triode 34 is the voltage dividing level of the input power supply through the seventh voltage dividing resistor 32 and the eighth voltage dividing resistor 33, so that the third triode 34 is turned on. When the fifth on-off state of the third photocoupler 31 is the off state, the third triode 34 is in the off state.

The third triode 34 is configured to control a sixth on-off state of the third triode 34 based on the fifth on-off state, to determine a level at the gate of the MOS 36 based on the sixth on-off state.

It should be noted that when the fifth on-off state of the third photocoupler 31 is the on state, the level at the base electrode of the third triode 34 is the voltage dividing level of the input power supply through the seventh voltage dividing resistor 32 and the eighth voltage dividing resistor 33. Since the level at the emitting electrode of the third triode 34 is the level of the input power supply, the sixth on-off state of the third triode 34 is the on state. When the fifth on-off state of the third photocoupler 31 is the off state, the sixth on-off state of the third triode 34 is also the off state.

The ninth voltage dividing resistor 35 is configured to form a fifth voltage dividing circuit with the tenth voltage dividing resistor 37, to use the voltage dividing level obtained by dividing the input power supply through the fifth voltage dividing circuit as the level at the gate of the MOS 36 when the sixth on-off state is an off state.

When the sixth on-off state of the third triode 34 is the off state, the level at the gate of the MOS 36 is the voltage dividing level of the input power supply through the ninth voltage dividing resistor 35 and the tenth voltage dividing resistor 37, so that the MOS 36 is turned on. When the sixth on-off state of the third triode 34 is the on state, the level at the gate of the MOS 36 is the level of the input power supply, and at this time, the MOS 36 is in the off state (turned off).

For example, the input power supply is 24V, and if the ninth voltage dividing resistor 35 is the same as the tenth voltage dividing resistor 37, the level at the gate of the MOS 36 is 12V.

The MOS 36 is configured to control a seventh on-off state of the MOS 36 based on the sixth on-off state, to control the switching state of the input power supply based on the seventh on-off state.

It should be noted that when the sixth on-off state of the third triode 34 is the off state, the level at the gate of the MOS 36 is the voltage dividing level of the input power supply through the ninth voltage dividing resistor 35 and the tenth voltage dividing resistor 37, the seventh on-off state of the MOS 36 is the on state. At this time, the input power supply is turned on, that is, the input power supply is successfully connected to the digital output functional circuit. When the sixth on-off state of the third triode 34 is the on state, the level at the gate of the MOS 36 is the level of the input power supply, so the seventh on-off state of the MOS 36 is the off state. At this time, the input power supply is not turned on, that is, the input power supply cannot be successfully connected to the digital output functional circuit, that is, the input power supply is cut off.

It can be understood that only when the power control signal sent by the control IC is a low-level signal, the input power supply of the digital output functional circuit can be turned on. Correspondingly, when the power control signal sent by the control IC is a high-level signal, the input power supply is cut off, that is, the digital output functional circuit has no input power.

In this embodiment, through the digital output power control circuit, the switching state of the input power supply can be controlled based on the leakage current detection result to ensure that the input power supply is turned off in time when there is a leakage current, thereby further improving the functional safety of the digital output.

Further, based on the above first embodiment to the sixth embodiment, the present disclosure provides a seventh embodiment of the digital output circuit.

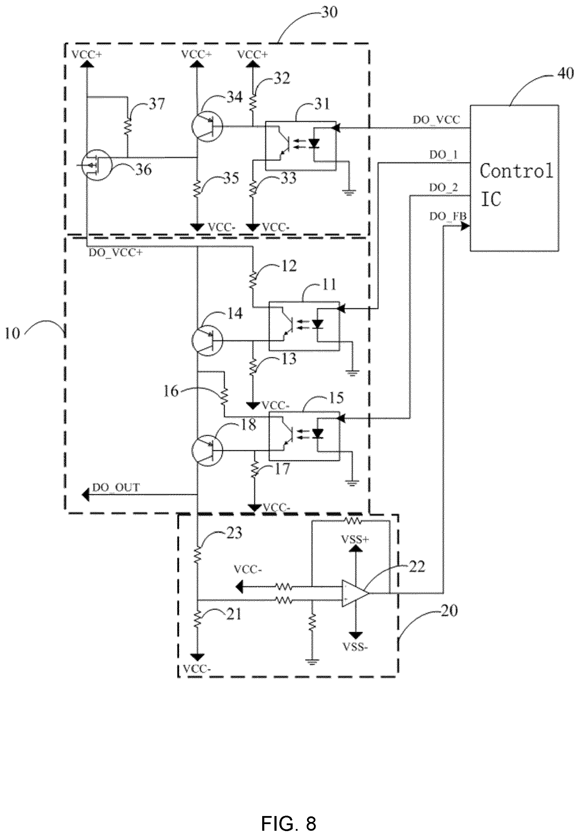

As shown in FIG. 8, FIG. 8 is a schematic structural diagram of the digital output circuit according to a seventh embodiment of the present disclosure.

In this embodiment, the digital output circuit further includes a control IC 40. A first control output pin of the control IC 40 is electrically connected to the digital output functional circuit. A second control output pin of the control IC 40 is electrically connected to the digital output functional circuit. An analog input pin of the control IC is electrically connected to the digital output leakage current detection circuit. A power control output pin of the control IC is electrically connected to the digital output power control circuit.

As shown in FIG. 8, the first control output pin DO_1 of the control IC 40 is electrically connected to the positive electrode of the input end of the first photocoupler 11 in the digital output functional circuit 10. The second control output pin DO_2 of the control IC 40 is electrically connected to the positive electrode of the input end of the second photocoupler 15 in the digital output functional circuit. The analog input pin DO_FB of the control IC 40 is electrically connected to the output end of the differential operational amplifier 22 in the digital output leakage current detection circuit 20. The power control output pin DO_VCC of the control IC 40 is electrically connected to the positive electrode of the input end of the third photocoupler 31 in the digital output power control circuit 30.

The control IC 40 is configured to control the level of the digital signal based on a first control signal of the first control output pin and a second control signal of the second control output pin.

In this embodiment, based on the first control signal of the first control output pin and the second control signal of the second control output pin, the specific execution process of controlling the level of the digital signal may refer to the second embodiment and the third embodiment, which will not be repeated herein.

The control IC 40 is further configured to receive an analog quantity sent by the digital output leakage current detection circuit, and determine a leakage current detection result based on the analog quantity.

In this embodiment, the specific execution process of receiving the analog quantity sent by the digital output leakage current detection circuit and determining the leakage current detection result based on the analog quantity may refer to the above-mentioned fourth and fifth embodiments, and will not be repeated herein.

The control IC 40 is further configured to control the switching state of the input power supply based on the leakage current detection result.

In this embodiment, the specific execution process of receiving and controlling the switching state of the input power supply based on the leakage current detection result may refer to the above sixth embodiment, which will not be repeated herein.

The digital output circuit is centrally controlled by the control IC, so that the digital output circuit can perform the corresponding signal function more accurately, thereby further improving the functional safety of the digital output.

The present disclosure further provides a digital output device, including the digital output circuit described in any one of the above embodiments.

The specific embodiments of the digital output device of the present disclosure are basically the same as the above-mentioned embodiments of the digital output circuit, and are not repeated herein.

The present disclosure further provides a digital output system, including: an input power supply device, an upper computer, and the digital output circuit described in any one of the above embodiments.

The input power supply device is configured to supply power to the digital output circuit.

It should be noted that the input power supply device is a device that provides input power supply, and the input power supply is the input power supply in the digital output circuit described in any one of the above embodiments.

The upper computer is configured to receive digital signal output by the digital output circuit.

It should be noted that the upper computer is a controlled device, and the upper computer is the upper computer in the digital output circuit described in any one of the above embodiments.

The specific embodiments of the digital output system of the present disclosure are basically the same as the above-mentioned embodiments of the digital output circuit, and will not be repeated herein.

It should be noted that in this document, the terms "comprise", "include" or any other variants thereof are intended to cover a non-exclusive inclusion. Thus, a process, method, article, or system that includes a series of elements not only includes those elements, but also includes other elements that are not explicitly listed, or also includes elements inherent to the process, method, article, or system. If there are no more restrictions, the element defined by the sentence "including a..." does not exclude the existence of other identical elements in the process, method, article or system that includes the element.

The serial numbers of the foregoing embodiments of the present disclosure are only for description, and do not represent the advantages and disadvantages of the embodiments.

Through the description of the above embodiment, those skilled in the art can clearly understand that the above-mentioned embodiments can be implemented by software plus a necessary general hardware platform, of course, it can also be implemented by hardware, but in many cases the former is a better implementation. Based on this understanding, the technical solution of the present disclosure can be embodied in the form of software product in essence or the part that contributes to the existing technology. The computer software product is stored on a storage medium (such as ROM/RAM, magnetic disk, optical disk) as described above, including several instructions to cause a terminal device (such as, a mobile phone, a computer, a server, or a network device, etc.) to execute the method described in each embodiment of the present disclosure.

The above are only some embodiments of the present disclosure, and do not limit the scope of the present disclosure thereto. Under the inventive concept of the present disclosure, equivalent structural transformations made according to the description and drawings of the present disclosure, or direct/indirect application in other related technical fields are included in the scope of the present disclosure.

## Claims

1. A digital output circuit, **characterized by** comprising:
a digital output functional circuit; and
a digital output leakage current detection circuit electrically connected to the digital output functional circuit,
wherein the digital output functional circuit is configured to turn on electrical connection between an input power supply and an upper computer to provide digital signal for the upper computer, and the digital output leakage current detection circuit is configured to perform leakage current detection on the digital signal, to control a switching state of the input power supply based on the leakage current detection result.

2. The digital output circuit of claim 1, wherein:
the digital output functional circuit comprises a first photocoupler, a first voltage dividing resistor, a second voltage dividing resistor and a first triode;
a positive electrode of an input end of the first photocoupler is electrically connected to a control integrated circuit (IC);
a negative electrode of the input end of the first photocoupler is grounded;
a positive electrode of an output end of the first photocoupler is electrically connected to a positive electrode of the input power supply through the first voltage dividing resistor;
a negative electrode of the output end of the first photocoupler is electrically connected to a first end of the second voltage dividing resistor;
a second end of the second voltage dividing resistor is electrically connected to a negative electrode of the input power supply or grounded;
the negative electrode of the output end of the first photocoupler is electrically connected to a base electrode of the first triode;
an emitting electrode of the first triode is electrically connected to the positive electrode of the input power supply;
a collector electrode of the first triode is electrically connected to the upper computer;
the first photocoupler is configured to receive a first control signal sent by the control IC, to control a first on-off state of the first photocoupler based on the first control signal;
the first voltage dividing resistor is configured to form a first voltage dividing circuit with the second voltage dividing resistor, to use a voltage dividing level obtained by dividing the input power supply through the first voltage dividing circuit as a level at the base electrode of the first triode when the first on-off state is an on-state; and
the first triode is configured to control a second on-off state of the first triode based on the first on-off state, to control a level of the digital signal.

3. The digital output circuit of claim 2, wherein:
the digital output functional circuit further comprises a second photocoupler, a third voltage dividing resistor, a fourth voltage dividing resistor and a second triode;
a positive electrode of an input end of the second photocoupler is electrically connected to the control IC;
a negative electrode of the input end of the second photocoupler is grounded;
a positive electrode of an output end of the second photocoupler is electrically connected to the collector electrode of the first triode through the third voltage dividing resistor;
a negative electrode of the output end of the second photocoupler is electrically connected to a first end of the fourth voltage dividing resistor;
a second end of the fourth voltage dividing resistor is electrically connected to the negative electrode of the input power supply or grounded;
the negative electrode of the output end of the second photocoupler is electrically connected to a base electrode of the second triode;
an emitting electrode of the second triode is electrically connected to the collector electrode of the first triode;
a collector electrode of the second triode is electrically connected to the upper computer;
the second photocoupler is configured to receive a second control signal sent by the control IC, to control a third on-off state of the second photocoupler based on the second control signal;
the third voltage dividing resistor is configured to form a second voltage dividing circuit with the fourth voltage dividing resistor, to use a voltage dividing level obtained by dividing the input power supply through the second voltage dividing circuit as a level at the base electrode of the second triode when the third on-off state is an on-state; and
the second triode is configured to control a fourth on-off state of the second triode based on the third on-off state, to control a level of the digital signal.

4. The digital output circuit of claim 1, wherein:
the digital output leakage current detection circuit comprises a fifth voltage dividing resistor and a differential operational amplifier;
a first end of the fifth voltage dividing resistor is electrically connected to an output end of the digital output functional circuit;
a second end of the fifth voltage dividing resistor is electrically connected to a negative electrode of the input power supply or grounded;
a non-inverting input end of the differential operational amplifier is electrically connected to the output end of the digital output functional circuit;
an inverting input end of the differential operational amplifier is electrically connected to the negative electrode of the input power supply or grounded;
an output end of the differential operational amplifier is electrically connected to the control IC;
the fifth voltage dividing resistor is configured to divide the digital signal, to use the voltage dividing level as a level at the non-inverting input end of the differential operational amplifier; and
the differential operational amplifier is configured to amplify the level at the non-inverting input end, and output the amplified analog quantity to the control IC for the control IC to perform leakage current detection based on the analog quantity.

5. The digital output circuit of claim 4, wherein:
the digital output leakage current detection circuit further comprises a sixth voltage dividing resistor;
a first end of the sixth voltage dividing resistor is electrically connected to the output end of the digital output functional circuit;
a second end of the sixth voltage dividing resistor is electrically connected to the first end of the fifth voltage dividing resistor; and
the sixth voltage dividing resistor is configured to form a third voltage dividing circuit with the fifth voltage dividing resistor to use the voltage dividing level obtained by dividing the digital signal as the level at the non-inverting input end of the differential operational amplifier.

6. The digital output circuit of claim 1, wherein:
the digital output circuit further comprises a digital output power control circuit electrically connected to the input power supply and the digital output functional circuit; and
the digital output power control circuit is configured to control the switching state of the input power supply based on the leakage current detection result of the digital output leakage current detection circuit.

7. The digital output circuit of claim 6, wherein:
the digital output power control circuit comprises a third photocoupler, a seventh voltage dividing resistor, an eighth voltage dividing resistor, a third triode, a ninth voltage dividing resistor, a metal oxide semiconductor field effect transistor MOS and a tenth voltage dividing resistor;
a positive electrode of an input end of the third photocoupler is electrically connected to the control IC;
a negative electrode of the input end of the third photocoupler is grounded;
a positive electrode of an output end of the third photocoupler is electrically connected to a positive electrode of the input power supply through the seventh voltage dividing resistor;
a negative electrode of the output end of the third photocoupler is electrically connected to a first end of the eighth voltage dividing resistor;
a second end of the eighth voltage dividing resistor is electrically connected to a negative electrode of the input power supply or grounded;
the positive electrode of the output end of the third photocoupler is electrically connected to a base electrode of the third triode;
an emitting electrode of the third triode is electrically connected to the positive electrode of the input power supply;
a collector electrode of the third triode is electrically connected to a first end of the ninth voltage dividing resistor;
a second end of the ninth voltage dividing resistor is electrically connected to the negative electrode of the input power supply or grounded;
a source of the MOS is electrically connected to the positive electrode of the input power supply;
a gate of the MOS is electrically connected to the positive electrode of the input power supply through the tenth voltage dividing resistor;
the gate of the MOS is electrically connected to the collector electrode of the third triode;
a drain of the MOS is electrically connected to an input power supply end of the digital output functional circuit;
the third photocoupler is configured to receive a power supply control signal sent by the control IC, to control a fifth on-off state of the third photocoupler based on the power supply control signal;
the seventh voltage dividing resistor is configured to form a fourth voltage dividing circuit with the eighth voltage dividing resistor, to use the voltage dividing level obtained by dividing the input power through the fourth voltage dividing circuit as a level at the base electrode of the third triode when the fifth on-off state is an on state;
the third triode is configured to control a sixth on-off state of the third triode based on the fifth on-off state, to determine a level at the gate of the MOS based on the sixth on-off state;
the ninth voltage dividing resistor is configured to form a fifth voltage dividing circuit with the tenth voltage dividing resistor, to use the voltage dividing level obtained by dividing the input power supply through the fifth voltage dividing circuit as the level at the gate of the MOS when the sixth on-off state is an off state; and
the MOS is configured to control a seventh on-off state of the MOS based on the sixth on-off state, to control the switching state of the input power supply based on the seventh on-off state.

8. The digital output circuit of claim 1, further comprising:
a control IC,
wherein:
a first control output pin of the control IC is electrically connected to the digital output functional circuit;
a second control output pin of the control IC is electrically connected to the digital output functional circuit;
an analog input pin of the control IC is electrically connected to the digital output leakage current detection circuit;
a power control output pin of the control IC is electrically connected to the digital output power control circuit;
the control IC is configured to control the level of the digital signal based on a first control signal of the first control output pin and a second control signal of the second control output pin;
the control IC is further configured to receive an analog quantity sent by the digital output leakage current detection circuit, and determine a leakage current detection result based on the analog quantity; and
the control IC is further configured to control the switching state of the input power supply based on the leakage current detection result.

9. A digital output device, **characterized by** comprising:
a digital output circuit, comprising:
a digital output functional circuit; and
a digital output leakage current detection circuit electrically connected to the digital output functional circuit,
wherein the digital output functional circuit is configured to turn on electrical connection between an input power supply and an upper computer to provide digital signal for the upper computer, and the digital output leakage current detection circuit is configured to perform leakage current detection on the digital signal, to control a switching state of the input power supply based on the leakage current detection result.

10. A digital output system, **characterized by** comprising:
an input power supply device;
an upper computer; and
a digital output circuit,
wherein:
the input power supply device is configured to supply power to the digital output circuit;
the upper computer is configured to receive digital signal output by the digital output circuit;
the digital output circuit comprises a digital output functional circuit and a digital output leakage current detection circuit electrically connected to the digital output functional circuit;
the digital output functional circuit is configured to turn on electrical connection between an input power supply and the upper computer to provide the digital signal for the upper computer, and the digital output leakage current detection circuit is configured to perform leakage current detection on the digital signal, to control a switching state of the input power supply based on the leakage current detection result.
